# EUROPÄISCHE PATENTSCHRIFT

(11) **EP 1 368 669 B1**
(45) Veröffentlichungstag und Bekanntmachung des Hinweises auf die Patenterteilung: **20.10.2004**
(21) Anmeldenummer: 02748305.6
(22) Anmeldetag: 01.03.2002
(51) Int. Cl.: G01R 31/28, H04B 17/00

(54) **VERFAHREN ZUM TESTEN EINER MESSAUFNAHMEEINRICHTUNG SOWIE ENTSPRECHENDE TESTEINRICHTUNG**
METHOD FOR TESTING A MEASUREMENT RECORDING DEVICE AND CORRESPONDING TESTING DEVICE
PROCEDE POUR ESSAYER UN DISPOSITIF CAPTEUR DE MESURES ET DISPOSITIF D'ESSAI ASSOCIE

(30) Priorität: 02.03.2001 DE 10110207
(43) Veröffentlichungstag der Anmeldung: 10.12.2003
(73) Patentinhaber: Willtek Communications GmbH, 85737 Ismaning (DE)
(72) Erfinder: KAINDL, Rolf, 85354 Freising (DE)
(74) Vertreter: Verscht, Thomas K.
(86) Internationale Anmeldenummer: PCT/DE2002/000742
(87) Internationale Veröffentlichungsnummer: WO 2002/071085

(56) Entgegenhaltungen:
- US-A- 5 854 559
- US-A- 6 125 107
- SCHOBLICK ET AL: "MESSTECHNIK FUER GSM-FUNKTELEFONE" FUNKSCHAU, FRANZIS-VERLAG K.G. MUNCHEN, DE, Bd. 16, Nr. 16, 1997, Seiten 64-66, XP001071210 ISSN: 0016-2841

## Beschreibung

Die vorliegende Erfindung betrifft ein Verfahren zum Testen einer Meßaufnahmeeinrichtung, welche in einem ersten Testbetriebsmodus zum Testen von Funkeinrichtungen zum einen mit einer Testeinrichtung zum Testen der Funkeinrichtungen und zum anderen mit einer Funkeinrichtung gekoppelt bzw. koppelbar ist. Ferner betrifft die vorliegende Erfindung eine Testeinrichtung zum Testen von Funkeinrichtungen, wie z. B. von zum Betrieb an einem Mobilfunknetz vorgesehenen Mobiltelefonen, welche in einem ersten Testbetriebsmodus zum Testen von Funkeinrichtungen mit den Funkeinrichtungen über eine Meßaufnahmeeinrichtung gekoppelt bzw. koppelbar ist. Schließlich betrifft die vorliegende Erfindung eine Verwendung einer Testeinrichtung zum Testen von Funkeinrichtungen zum Testen einer daran gekoppelten Meßaufnahmeeinrichtung mittels einer Impedanzmessung.

Im Stand der Technik sind Testeinrichtungen zum Testen von Mobiltelefonen bekannt. Derartige Testeinrichtungen, werden insbesondere in Produktionsstätten und Servicecentem dazu verwendet, Mobiltelefone zur Einhaltung der für den Betrieb erforderlichen Spezifikationen zu testen. In einer bekannten Anwendung werden alle möglichen Typen von Mobiltelefonen bzw. Handys mit Hilfe von speziellen Meßaufnahmeeinrichtungen bzw. Test-Adaptern auf Abweichungen von den geforderten Spezifikationen getestet. Als Ergebnis des Testes werden schadhafte Mobiltelefone aussortiert bzw. repariert. Die für Mobiltelefone einzuhaltenden Spezifikationen sind dabei so eng, daß geringe Meßfehler in der Größenordnung von einigen Zehntel dB bereits problematisch sind. In der Produktion besitzen derartige Meßaufnahmeeinrichtungen einen hohen Durchsatz von einigen tausend Mobiltelefonen pro Tag und sind daher hohen, insbesondere mechanischen, Belastungen ausgesetzt. Die Mobiltelefone werden beispielsweise pneumatisch in die Meßaufnehmer gepreßt und wieder herausgenommen. Bereits geringe Abweichungen in Übergangswiderständen, wie sie beispielsweise durch Verunreinigungen hervorgerufen werden, oder in elektrischen Eigenschaften von Schaltern oder Kabeln (lose Verbindungen, Quetschungen etc.) führen zu Abweichungen der Meßergebnisse und somit zu einer Verringerung der Produktionsausbeute bzw. zu ansprechend auf das Testergebnis fehlerhaft durchgeführten Abgleichmaßnahmen. Die bekannten Meßaufnahmeeinrichtungen, welche insbesondere in der Produktion von Mobiltelefonen eingesetzt werden, haben somit einen wesentlichen Einfluß auf die Genauigkeit der Messungen und damit auch auf den sogenannten Yield bzw. die Produktionsausbeute. Insbesondere aufgrund der großen mechanischen Belastungen ist eine Überprüfung der Qualität der Meßaufnahmeeinrichtungen von Zeit zu Zeit erforderlich.

Es ist nun im Stand der Technik bekannt, Tests für die Meßaufnahmeeinrichtungen bzw. Testadapter, aus der Produktionsanordnung "herausgelöst" in einer Phase der Unterbrechung des Testbetriebs für die Funkeinrichtungen, mittels eines sogenannten Vierpol-Meßplatzes durchzuführen. Ein derartiger Vierpol-Meßplatz ist nicht nur sehr teuer, sondern benötigt auch entsprechende Adaptionen um zum Testen einer Meßaufnahmeeinrichtung angepaßt zu werden. Der hierzu erforderliche komplexe Testaufbau gestattet auch keine regelmäßige Kontrollmessung während des Produktionsbetriebes, da dieser zum Überprüfen der Qualität unterbrochen werden muß. Dies verursacht nicht nur einen hohen Aufwand sondern stört auch den Produktionsablauf, wodurch sich unakzeptable Produktionseinbußen ergeben. Die erforderliche Unterbrechung des Produktionsbetriebes hat zur Folge, daß ein Testen der Meßaufnahmeeinrichtung nur dann durchgeführt wird, wenn die Wahrscheinlichkeit für eine Degradation der Meßaufnahmeeinrichtung hinreichend hoch ist. Dies bedeutet aber wiederum, daß unter Umständen eine Vielzahl von Mobiltelefonen fehlerhaft getestet bzw. falsch abgeglichen wurden.
Die Aufgabe der vorliegenden Erfindung besteht daher darin, die Nachteile des Standes der Technik zu vermeiden, und insbesondere ein Verfahren anzugeben, mit welcher eine Meßaufnahmeeinrichtung für Mobiltelefone in einer realen Produktionsumgebung ohne Unterbrechung des Produktionsablaufs getestet werden kann.

Bei einem Verfahren der eingangs genannten Art wird die erfindungsgemäße Aufgabe dadurch gelöst, daß ein zweiter Testbetriebsmodus zum Testen der Meßaufnahmeeinrichtung vorgesehen ist, in welchem die Meßaufnahmeeinrichtung zum einen mit der Testeinrichtung zum Testen der Funkeinrichtungen und zum anderen mit einer definierten bzw. im wesentlichen definierten Abschlußimpedanz gekoppelt ist, wobei die Meßaufnahmeeinrichtung von der Testeinrichtung zum Testen von Funkeinrichtungen getestet wird.

Ein besonderer Vorteil der vorliegenden Erfindung besteht darin, daß das Testen nicht durch ein gesondertes Gerät mit großem technischen Aufwand erfolgt, sondern mit einer ohnehin, wenn auch zu einem anderen Zweck, nämlich zum Testen der Mobiltelefone, vorgesehenen Testeinrichtung bzw. Funkmeßplatz, erfolgt.

Ein weiter Vorteil der vorliegenden Erfindung besteht darin, daß das erfindungsgemäße Testverfahren vollautomatisch, d. h. ohne Einschaltung von Bedienungspersonal, ablaufen kann und somit den Produktionsablauf nur minimal beeinträchtigt und zusätzliche Kapazitäten für das Bedienungspersonals schafft.

Schließlich ist ein weiterer Vorteil der vorliegenden Erfindung, daß das erfindungsgemäße Testverfahren kontinuierlich, z. B. in regelmäßigen Zeitabständen, durchgeführt werden kann und insbesondere so schnell ist, daß in bestehende Produktionsprozesse nur minimal eingegriffen werden muß.

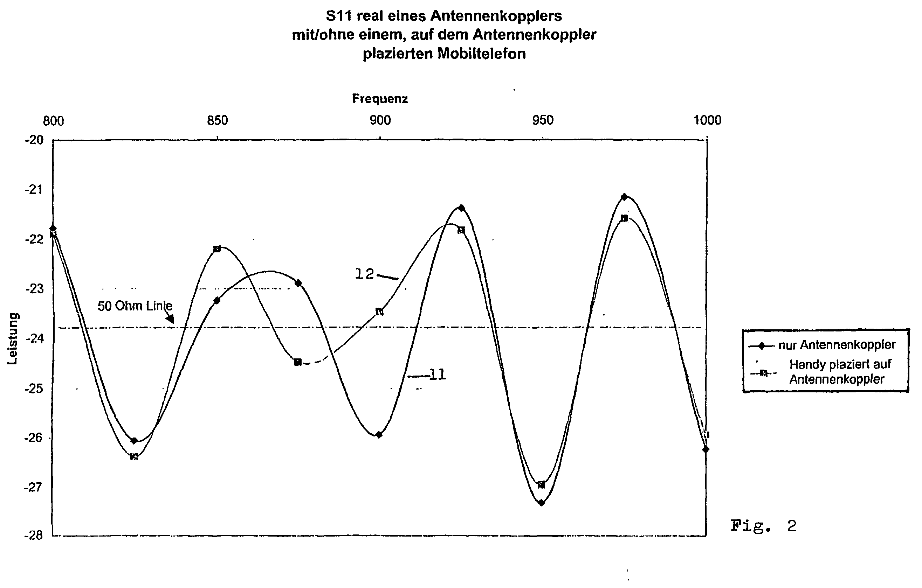

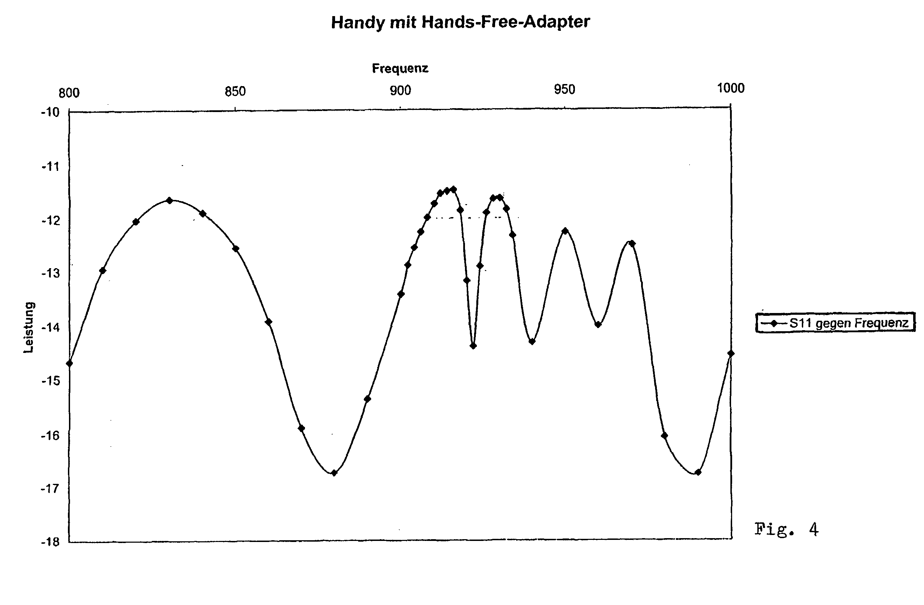

Bevorzugt wird zum Testen der Meßaufnahmeeinrichtung die Impedanz der Meßaufnahmeeinrichtung, vorzugsweise der Realteil der Impedanz, als Funktion der Frequenz durch die Testeinrichtung aufgenommen. Aufgrund von Versuchen wurde herausgefunden, vgl. dazu auch die der Anmeldung beigefügten Figuren 2 bis 5, daß sich der Verlauf der Impedanz der Meßaufnahmeeinrichtung als Funktion der Frequenz hervorragend dazu eignet, meßtechnisch relevante Degradationen der Meßaufnahmeeinrichtung zu detektieren. Besonders bevorzugt ist eine Reflektionsmessung, bei welcher die Leistung gemessen wird, und welche im Wesentlichen durch den Realteil der Impedanz der Meßaufnahmeeinrichtung beeinflußt wird. Eine Leistungsmessung ist insbesondere auch deshalb bevorzugt, weil in einer realen Testeinrichtung zum Testen von Mobiltelefonen bereits ein derartiger Leistungsmesser integriert ist. Der erfindungsgemäße zweite Testbetriebsmodus kann dabei auf einer einzigen bzw. mehreren diskreten Frequenzen oder aber auch über ein Frequenzband durchgeführt werden.

Vorteilhafterweise weist die Testeinrichtung zum Testen von Funkeinrichtungen Signalgeneratormittel und Empfangsmittel auf, welche über einen einzigen I/O-Anschluß miteinander verbunden sind, wobei die Meßaufnahmeeinrichtung mit dem I/O-Anschluß verbunden ist, und wobei wenigstens ein, in dem zweiten Testbetriebsmodus von den Signalgeneratormitteln erzeugtes Signal von den Empfangsmitteln aufgenommen und mit wenigstens einem vorgespeicherten Referenzwert verglichen wird. Auf diese Weise wird in dem zweiten Testbetriebsmodus insbesondere eine Relativmessung erreicht. Anschaulich gesprochen, kann hierdurch in dem zweiten Testbetriebsmodus ein elektrischer "Fingerabdruck" der Meßaufnahmeeinrichtung aufgenommen werden, und in nachfolgenden Messungen dieser auf seine Veränderung bzw. Konstanz hin überprüft werden.

Vorzugsweise werden die Signalgeneratormittel und die Empfangsmittel in dem zweiten Testbetriebsmodus synchron in der Frequenz über einen vorgegebenen Frequenzbereich verstimmt. Durch die synchrone Frequenzverstimmung von Signalgeneratormitteln und Empfangsmitteln wird eine optimale Meßempfindlichkeit des erfindungsgemäßen zweiten Testbetriebsmodus erzielt.

Eine meßtechnisch bevorzugte Variante der Erfindung sieht vor, daß der vorgegebene Frequenzbereich wenigstens einen Betriebsfrequenzbereich einer Funkeinrichtung aufweist. Die Verwendung von Testfrequenzen in wenigstens einem Betriebsfrequenzbereich der Funkeinrichtung stellt zum einen sicher, daß ausreichend viele Frequenzen verwendet werden, welche zur Definition eines "Fingerabdrucks" der Meßaufnahmeeinrichtung geeignet sind. Ferner ist in der Regel die Meßaufnahmeeinrichtung derart ausgelegt, daß für die Betriebsfrequenzen der Funkeinrichtung normalerweise wenig störende Effekte, wie z. B. Resonanzen oder dergleichen, auftreten. Schließlich ist dies auch deshalb bevorzugt, da die Testeinrichtung zum Testen der Mobiltelefone für derartige Frequenzbereiche optimiert ist und gerade auf diesen Frequenzbereichen sich Beeinträchtigungen in der Meßaufnahmeeinrichtung besonders ungünstig auf den Funktionstest der Mobiltelefone auswirken.

Vorzugsweise erfolgt die Frequenzverstimmung schrittweise. Eine schrittweise Frequenzverstimmung hat den Vorteil, daß hierdurch in einfacher und schneller Art und Weise die Signalgeneratormittel und Empfangsmittel synchron verstimmt werden können. Außerdem kann hierdurch in einfacher Weise der gesamte Frequenzbereich abgedeckt werden.

Zur einfacheren Auswertung der Signale ist bevorzugt, daß der Pegel der von den Signalgeneratormitteln erzeugten Signale während der Frequenzverstimmung konstant ist. Durch die Bereitstellung eines konstanten Pegels wird die Auswertung der in dem Leistungsmesser empfangenen Signale hinreichend vereinfacht.

Vorzugsweise wird eine über den Frequenzbereich aufgenommene Meßkurve mit einer Referenzkurve verglichen. Auf diese Weise kann eine optimale Charakteristik der Meßaufnahmeeinrichtung verwendet werden. Die Referenzkurve ist dabei vorzugsweise eine Kurve, welche aufgenommen wurde, wenn sichergestellt ist, daß die Meßaufnahmeeinrichtung sich in einem ordnungsgemäßen Betriebszustand befindet. Alternativ dazu kann die Referenzkurve auch eine theoretisch ermittelte Kurve sein. Schließlich ist denkbar, daß die Referenzkurve meßtechnisch bestimmte Anteile und theoretisch bestimmte Anteile aufweist.

Um die Messung der Meßaufnahmeeinrichtung wiederholt auszuführen und in den Testbetrieb für die Funkeinrichtungen zu integrieren, ist bevorzugt, daß der zweite Testmodus intermittierend zu dem ersten Testmodus durchgeführt wird. Da das erfindungsgemäße Meßverfahren weniger als eine Sekunde dauert, ist eine, insbesondere mehrmalige, Unterbrechung des ersten Testmodus bevorzugt, wobei in dieser Unterbrechung nach einem abgeschlossenem Test eines Mobiltelefons gemäß dem ersten Betriebsmodus der erfindungsgemäße Test der Meßaufnahmeeinrichtung in dem zweiten Testbetriebsmodus durchgeführt wird. Hierdurch wird insbesondere sichergestellt, daß eine Degradation der Meßaufnahmeeinrichtung während des laufenden Testbetriebs mit ausreichend hoher Sicherheit erkannt wird.

Vorteilhafterweise weist die Meßaufnahmeeinrichtung die Abschlußimpedanz auf. Dabei ist bevorzugt, daß die Abschlußimpedanz ein Antennenkoppler ist. In dem Fall, in welchem die Meßaufnahmeeinrichtung selbst eine reproduzierbare Abschlußimpedanz aufweist, ist die Durchführung des erfindungsgemäßen Verfahrens besonders einfach. Ohne weitere Maßnahmen durchzuführen, kann der erfindungsgemäße zweite Testbetriebsmodus zum Testen der Meßaufnahmeeinrichtung verwendet werden.

Ebenfalls ist bevorzugt, daß die Abschlußimpedanz eine Test-Funkeinrichtung ist. Dabei ist die Test-Funkeinrichtung vorzugsweise ein unbestücktes Mobiltelefon, welches eine Ersatzlast bzw. eine Ersatzabschlußimpedanz für eine koaxiale Verbindung der Meßaufnahmeeinrichtung und einem zu testenden Mobiltelefon aufweist. Dieses Ausführungsbeispiel ist besondere bevorzugt, wenn die Meßaufnahmeeinrichtung, wie sie beispielsweise in einer laufenden Produktionslinie eingesetzt wird, keine hinreichende reproduzierbare Abschlußimpedanz aufweist, um den erfindungsgemäßen zweiten Testbetriebsmodus zufriedenstellend auszuführen. In diesem Fall ist bevorzugt, daß die Meßaufnahmeeinrichtung mit einer derartigen, hinreichenden reproduzierbaren Abschlußimpedanz versehen wird, welche vorzugsweise eine Test-Funkeinrichtung ist, um den Besonderheiten in einer laufenden Produktionslinie gerecht zu werden. Die Produktionslinie muß dann nicht angepaßt werden, um den zweiten Testbetriebsmodus einzusetzen.

Zur praktischen Realisierung dieses Ausführungsbeispiels ist bevorzugt, daß die Test-Funkeinrichtung mehrfach in eine Produktions- oder Testlinie eingespeist wird, wobei Mittel vorgesehen sind, um die Test-Funkeinrichtung als solche zu erkennen, und um darauf ansprechend den zweiten Testbetriebsmodus auszulösen.

Vorteilhafterweise wird bei einer ausreichenden Abweichung der von den Empfangsmitteln aufgenommenen Signale von den Referenzkurven ein Alarm ausgelöst. Ein derartiger Alarm kann einfach eine Anzeige auf der Testeinrichtung sein, mit welcher einer Bedienungsperson die Qualität, und insbesondere einen nicht mehr ausreichende Qualität, der Meßaufnahmeeinrichtung angezeigt wird. Ebenfalls kann die Alarmeinrichtung aufwendiger gestaltet sein, und beispielsweise ein Signal senden, um eine Bedienungsperson herbeizurufen, um erforderliche Reparaturmaßnahmen einzuleiten. Der Alarm kann beispielsweise durch ein Aufleuchten der Lampe der Umwelt vermittelt werden, aber auch weitere Möglichkeiten sind denkbar, wie z. B. eine Mitteilung per Funk an ein entsprechendes portables Gerät welches von einer Bedienungsperson mitgeführt wird. Schließlich kann auch die Abweichung eines aufgenommenen Signals von der Soll- bzw. Referenzkurve dazu verwendet werden, daß automatisch verstellbare Komponenten in der Meßaufnahmeeinrichtung automatische nachkalibriert werden, wodurch sich nicht nur eine Autotest sondern auch eine "Autojustage" ergibt.

Vorzugsweise wird die Referenz bzw. eine Referenzkurve in einer im Testgerät vorgesehenen Spreichereinrichtung oder einem damit verbundenen externen Gerät, beispielsweise einem Computer, gespeichert.

Gemäß einem weiteren Aspekt wird die Aufgabe der vorliegenden Erfindung durch ein Testgerät zum Testen von Funkeinrichtungen gelöst, welche in einem ersten Testbetriebsmodus zum Testen von Funkeinrichtungen mit den Funkeinrichtungen über eine Meßaufnahmeeinrichtung gekoppelt ist, wobei das Testgerät einen zweiten Testbetriebsmodus zum Testen der Meßaufnahmeeinrichtung aufweist, in welchem die Meßaufnahmeeinrichtung zum einen mit der Testeinrichtung zum Testen der Funkeinrichtungen und zum anderen mit einer im wesentlichen definierten Abschlußimpedanz gekoppelt ist, wobei die Meßaufnahmeeinrichtung von der Testeinrichtung zum Testen von Funkeinrichtungen getestet wird.

Schließlich wird die Aufgabe der vorliegenden Erfindung ebenfalls durch eine Verwendung eines Testgeräts zum Testen von Funkeinrichtungen zum Testen einer daran gekoppelten Meßaufnahmeeinrichtung mittels einer Impedanzmessung gelöst.

Die Erfindung, sowie weitere Merkmale, Vorteile, Ziele und Anwendungsmöglichkeiten derselben wird bzw. werden nachfolgend anhand einer Beschreibung von bevorzugten Ausführungsformen näher erläutert. Dabei bilden alle beschriebenen und/oder bildlich dargestellten Merkmale für sich oder in beliebiger sinnvoller Kombination den Gegenstand der vorliegenden Erfindung, und zwar unabhängig von deren Zusammenfassung in den Ansprüchen oder deren Rückbeziehung. Überall in den Zeichnungen bezeichnen dieselben Bezugszeichen die gleichen bzw. entsprechende Elemente In den Zeichnungen zeigen:
- Fig. 1a: eine schematische Anordnung bestehend aus einer Testeinrichtung zum Testen von Mobiltelefonen und einer Meßaufnahmeeinrichtung zur Erläuterung eines ersten Ausführungsbeispiels des erfindungsgemäßen Verfahrens mit einer der Meßaufnahmeeinrichtung eigenen Abschlußimpedanz;
- Fig. 1b: eine schematische Anordnung bestehend aus einer Testeinrichtung zum Testen von Mobiltelefonen und einer Meßaufnahmeeinrichtung zur Erläuterung eines zweiten Ausführungsbeispiels des erfindungsgemäßen Verfahrens mit einer gesondert vorgesehenen Abschlußimpedanz für die Meßaufnahmeeinrichtung;
- Fig. 2: eine unter Verwendung des erfindungsgemäßen Verfahrens aufgenommene Meß-Kurve, welche den "S11 real"-Anteil der Impedanz eines Antennenkopplers mit und ohne Mobiltelefon auf der Halterung zeigt;
- Fig. 3: eine Kurve, vergleichbar derjenigen der Fig. 2, jedoch für den Fall, daß zwei unterschiedliche Kabel mit dem Antennenkoppler verbunden sind; und
- Fig. 4: eine den Fig. 2 und 3 entsprechende Kurve unter Verwendung eines GSM-Mobiltelefons in seinem handelsüblichen Hands-Free Adapter.

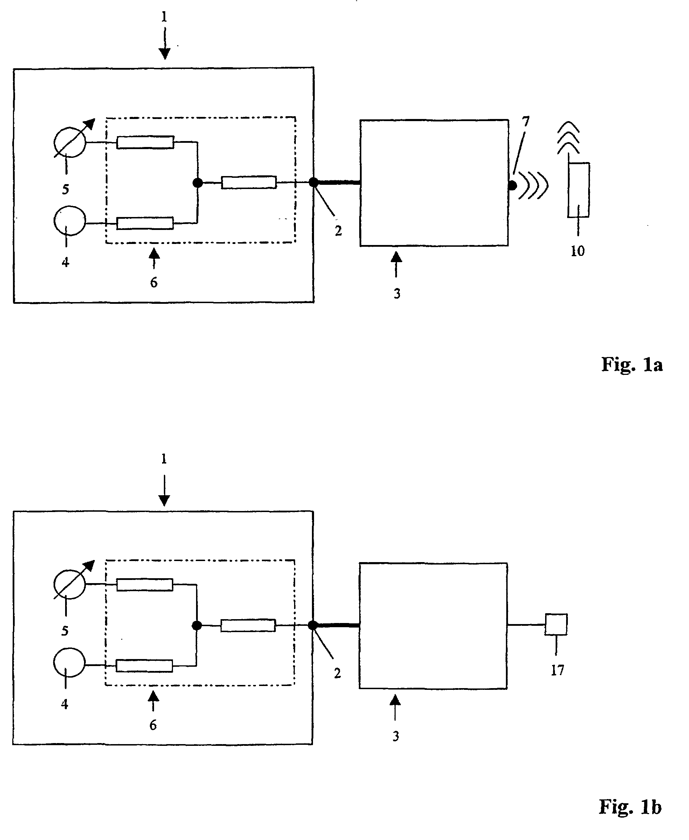

Anhand der Fig. 1a wird im folgenden ein erstes Ausführungsbeispiel der vorliegenden Erfindung näher erläutert. In Fig. 1a ist eine Testeinrichtung zum Testen von zum Betrieb an einem Mobilfunknetz vorgesehenen Funkeinrichtungen, wie z. B. Mobiltelefonen, ein sogenannter Funkmeßplatz 1, schematisch dargestellt. Der Funkmeßplatz 1 weist einen I/O-Anschluß 2 auf, an welchem eine Meßaufnahmeeinrichtung bzw. eine Testadaptereinrichtung 3 beispielsweise über ein Koaxialkabel angeschlossen ist. Gemäß der vorliegenden Erfindung wäre dann dieses Koaxialkabel der Meßaufnahmeeinrichtung zuzuordnen. Über die Meßaufnahmeeinrichtung 3 ist der Funkmeßplatz 1 mit einem Mobiltelefon 10 in einem ersten Testbetriebsmodus zum Testen der Spezifikationen desselben verbunden Die Mobiltelefone 10 werden beispielsweise in einer Produktionsstätte durch ein (nicht dargestelltes) Förderband jeweils neu angeliefert. Die Verbindung zwischen der Meßaufnahmeeinrichtung 3 und dem Mobiltelefon 10 kann dabei über einen Antennenkoppler, d. h. über die Luftschnittstelle (air interface), oder über eine Koaxialverbindung erfolgen. In dem ersten Ausführungsbeispiel der vorliegenden Erfindung wird davon ausgegangen, daß die Meßaufnahmeeinrichtung bereits eine hinreichend reproduzierbare Abschlußimpedanz aufweist. Dies ist, z. B. der Fall, wenn das Mobiltelefon 10 mit der Meßaufnahmeeinrichtung 3 über einen Antennenkoppler verbunden ist. In diesem Fall weist die Meßaufnahmeeinrichtung 3 eine Abschlußimpedanz in Form einer Antenne 7 auf. Hinsichtlich der Terminologie sei bemerkt, daß die Meßaufnahmeeinrichtung 3 alle Komponenten, wie insbesondere Kabel, Schalter und Kontakte, sowie den Antennenkoppler, umfaßt, welche zwischen dem I/O-Anschluß 2 des Funkmeßplatzes 1 und dem zu testenden Mobiltelefon 10 während des Testbetriebes verbunden sind. Die Meßaufnahmeinrichtung 3 kann daher sehr einfach aufgebaut sein und beispielsweise nur ein Kabel oder einen Stecker aufweisen. Ebenso kann die Meßaufnahmeeinrichtung aus vielen unterschiedlichen Komponenten aufgebaut sein. Der Funkmeßplatz 1 weist Signalgeneratormittel 4, insbesondere einen in der Frequenz verstimmbaren HF-Generator, und Empfangsmittel 5, insbesondere einen selektiven Leistungsmesser auf Über einen Z/3 Stern 6 ist der HF-Generator 4 und der Leistungsmesser 5 mit dem I/O-Anschluß 2 verbunden. Zum Testen der Meßaufnahmeeinrichtung 3 werden der HF-Generator 4 und der Leistungsmesser bzw. -empfänger 5 des Funkmeßplatzes 1 intern auf die gleiche Frequenz gestellt. Im Testbetrieb für die Meßaufnahmeeinrichtung 3, d. h. in dem zweiten Testbetriebsmodus, ist vorzugsweise kein Mobiltelefon 10 (entgegen der Darstellung der Zeichnung) an der Meßaufnahmeeinrichtung 3 angekoppelt. Dies hat den Vorteil, daß das Mobiltelefon nicht die Messung der Meßaufnahmeeinrichtung 3 beeinträchtigt. Über den Z/3 Stern 6 des Funkmeßplatzes 3 wird eine entsprechende Leistung des HF-Generators 4 mit dem Leistungsmesser 5 gemessen. Eine derartige Messung ist sehr präzise und besitzt eine Genauigkeit von ungefähr ± 0,2 dB. Aus der Sicht des Funkmeßplatzes 1 stellt die Meßaufnahmeeinrichtung 3 eine beliebige Last, d. h. eine komplexe Impedanz dar, welche die vom Leistungsmesser 5 gemessene Leistung des internen HF-Generators 4 beeinflußt. Genauer wird bei der bevorzugten Leistungsmessung nur der Realteil S 11 der Impedanz der Meßaufnahmeeinrichtung gemessen. Zu Testzwecken wird nun eine Referenzaufnahme eines individuellen Testaufbaus, d. h. einer realen Meßaufnahmeeinrichtung 3, mit beliebig vielen komplexen Komponenten erzeugt, welche einen ganz bestimmten typischen Verlauf der Amplitude über die Frequenz besitzt. Diese Referenzaufnahme wird durch schrittweises, synchrones Verstimmen des HF-Generators 4 und des Leistungsmessers 5 erzeugt. Eine jeweils zugeordnete Leistung wird von dem Empfänger 5 gemessen und gespeichert. Dabei wird der Pegel des HF-Generators 4 konstant gehalten. Der auf diese Weise erhaltene Kurvenzug wird als Referenzkurve dieses individuellen und realen Meßaufbaus im Funkmeßplatz 1 oder einem damit verbundenen Personalcomputer gespeichert. Nachfolgende Kontrollmessungen, welche insbesondere während des laufenden Testbetriebes für den Mobiltelefone, d. h. mit an die Meßaufnahmeeinrichtung 3 angeschlossenen Mobiltelefonen, gewonnen werden, werden mit dieser gespeicherten Referenz verglichen. Auf diese Weise kann eine relative Meßmethode realisiert werden, bei der selbst geringste Abweichungen der Meßanordnung, wie sich beispielsweise durch Verunreinigungen oder durch Änderung der elektrischen Eigenschaften von Schaltern und Kabeln ergeben, wiederholbar und genau erfaßt werden. Das erfindungsgemäße Meßverfahren kann vollautomatisch in weniger als einer Sekunde durchgeführt werden und ist daher beliebig häufig, je nach Bedarf anwendbar. In Abhängigkeit von einem Kriterium, welches die Abweichung der aufgenommenen Ist-Meßwertkurve von der Solloder Referenzmeßwertkurve anzeigt, kann eine Bewertung des Testergebnisses vorgenommen werden und darauf ansprechend erforderliche Maßnahmen eingeleitet werden. Diese können beispielsweise die Reparatur der Meßaufnahmeeinrichtung 3, der Austausch von Komponenten sein. Ebenfalls kann sich als Ergebnis der Testmessung ergeben, daß die Meßaufnahmeeinrichtung voll funktionsfähig ist. Verschiedene mathematische Verfahren, um die Abweichung zweier Kurven zu bewerten sind für die vorliegende Erfindung geeignet. Beispielsweise kann hierzu der absolute Betrag der Differenzfunktion der Soll- und Ist-Kurve integriert werden. Ebenfalls ist aber auch denkbar für alle oder bestimmte vorgegebene Frequenzen einen Schwellwert der Mindestabweichung vorzusehen.

Anhand von Fig. 1b wird im folgenden nun eine zweites Ausführungsbeispiel der vorliegenden Erfindung näher erläutert. Im Unterschied zu den zuvor beschriebenen ersten Ausführungsbeispiel der vorliegenden Erfindung besitzt die Meßaufnahmeeinrichtung selbst hierzu keine hinreichend reproduzierbare Abschlußimpedanz, so daß diese extern bereitgestellt werden muß. Es wird hierzu also kein Antennenkoppler verwendet. Eine Vielzahl von realen Meßanordnungen verwendet z. B. eine direkte koaxiale HF-Verbindung der Meßaufnahmeeinrichtung 3 mit dem Mobiltelefon 10. In diesem Fall ist das oben erläuterte Verfahren gemäß dem ersten Ausführungsbeispiel nicht anwendbar, da die Meßanordnung, d. h. die Meßaufnahmeeinrichtung 3, ein "offenes" Ende aufweist, wobei sich als Folge ergibt, daß das Meßergebnis weitgehend nur durch diesen extremen Fehlabschluß bestimmt wird. Alle übrigen, kleineren Einflüsse der Meßanordnung auf das Meßergebnis, deren Erfassen des eigentlichen Ziel der Überprüfung sind, werden dabei überdeckt. Bei dem zweiten Ausführungsbeispiel der vorliegenden Erfindung wird daher die Meßaufnahmeeinrichtung 3, im Unterschied zu dem ersten Testbetriebsmodus, ausgangsseitig (der Funkmeßplatz 1 ist eingangsseitig mit der Meßaufnahmeeinrichtung 3 verbunden) mit einer separaten, reproduzierbaren Abschlußimpedanz 17 versehen. Diese Abschlußimpedanz 17 entspricht in etwa der Abschlußimpedanz eines Mobiltelefons. Auf diese Weise ist es möglich die zu messenden Abweichungen in der Meßaufnahmeeinrichtung 3, wie sie z. B. durch unerwünschte Verunreinigungen oder Änderungen der elektrischen Eigenschaften von Schaltern und Kabeln verursacht werden, reproduzierbar und nicht überdeckt durch andere Effekte aufzunehmen. Zu Zwecken der Terminologie wird im vorliegenden zweiten Ausführungsbeispiel der vorliegenden Erfindung unter der Meßaufnahmeeinrichtung 3 der gesamte Meßaufbau jenseits des I/O-Anschlusses 2, jedoch ohne die erforderliche Abschlußimpedanz verstanden.

Die hier definierte Abschlußimpedanz 17 kann beispielsweise einfach zu Testzwecken auf die Koaxialverbindung an Stelle eines zu testenden Mobiltelefons entweder automatisch oder manuell aufgebracht werden. Vorzugsweise wird aber besonderes Verfahren zur Realisierung einer Abschlußimpedanz 17 vorgeschlagen. Bei dieser Ausführungsform der vorliegenden Erfindung wird ein spezielles "Dummy"-Mobiltelefon in die laufende Test- oder Produktionslinie eingespeist. Dieses zum Zwecke des Testes der Meßaufnahmeeinrichtung 3 vorgesehene Testmobiltelefon ist mechanisch voll identisch zu den real zu testenden Mobiltelefonen, so daß keine weiteren Veränderungen in der Produktionslinie erforderlich sind. Das Testmobiltelefon ist aber ein unbestücktes Standard Mobiltelefon oder ein unbestücktes Mobiltelefon-Board, welches lediglich mit einer Ersatz-Impedanz für den koaxialen Antennenanschluß versehen ist. Dabei ist die Genauigkeit dieser Ersatz-Impedanz in weiten Grenzen unerheblich. Sie muß nur hinreichend genau reproduzierbar sein, was insbesondere dadurch sichergestellt werden kann, daß immer das gleiche Test-Mobiltelefon für die Referenz- und Kontrollmessungen verwendet wird. Im laufenden Produktions-Testprogramm kann ein derartiges "Dummy"-Mobiltelefon jederzeit sicher aufgrund von Parametermessungen, welche sich, z. B. auf die Stromaufnahme beziehen, entdeckt werden und entsprechend vollautomatisch auf die Überprüfung der Meßanordnung verzweigen.

Zur Erläuterung des erfindungsgemäßen Verfahrens, und insbesondere im Hinblick auf deren Empfindlichkeit, ist in Fig. 2 der "S11 real"-Kurvenverlauf (gemessene Leistung gegen Frequenz) eines Antennenkopplers, wie er beispielsweise aus dem Deutschen Patent 197 32 639, dessen Inhaberin die Anmelderin der vorliegenden Patentanmeldung ist, unter zwei Bedingungen dargestellt. Dabei bezieht sich eine erste Kurve 11 auf einer erste Messung, bei welcher kein Mobiltelefon auf der Halterung des Antennenkopplers vorgesehen ist. Eine weitere Kurve 12 stellt den Verlauf der von dem Leistungsmesser 5 gemessenen Leistung als Funktion der Frequenz in dem Fall dar, in welchem ein Mobiltelefon auf der Halterung des Antennenkopplers vorgesehen ist. Man entnimmt der Darstellung der Fig. 2, daß sich besondere Abweichungen in dem Betriebsfrequenzbereich des Mobiltelefons ergeben. Aber auch in den übrigen Frequenzbereichen sind die Abweichungen der beiden Kurven so stark ausgeprägt, daß die veränderte Meßsituation (Antennenkoppler mit/ohne in der Halterung abgelegtem Mobiltelefon) erkannt wird.

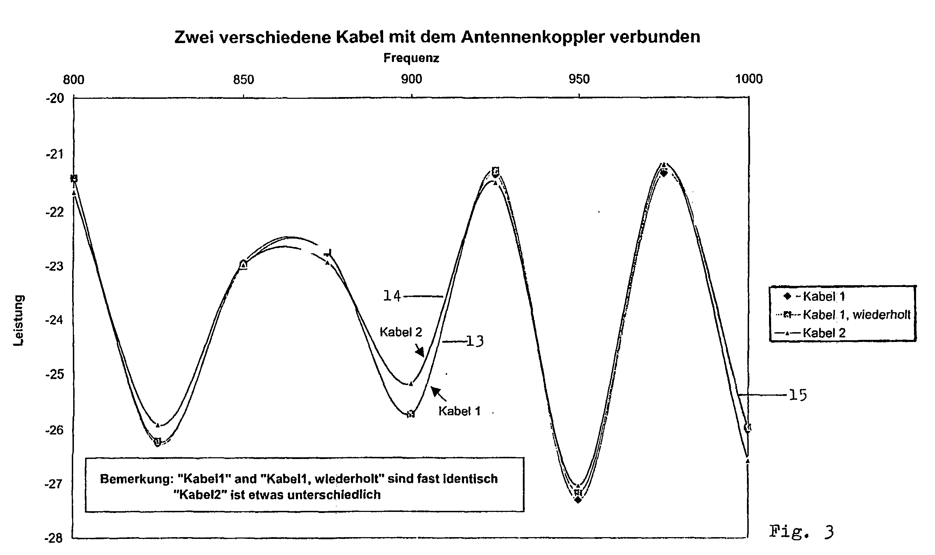

In Fig. 3 ist eine weitere aufgenommene Meßkurve gezeigt, bei welcher eine gemäß der vorliegenden Erfindung erhaltene Meßkurve (Leistung gegenüber Frequenz) dargestellt ist. Die Kurven 13 und 14 stellen das Meßergebnis dar, welches durch Verbindung eines Antennenkopplers mit zwei äußerlich gleichen, industriell gefertigten, hochwertigen Kabeln zeigt: Die beiden Kurven sind zwar über weite Bereiche des aufgenommenen Frequenzbereichs identisch, zeigen aber beispielsweise bei einer Frequenz von etwa 900 MHz eine deutliche Abweichung. Ebenfalls ist in der Fig. 3 eine Kurve 15 gezeigt, welche im allgemeinen der Kurve 13 entspricht, und welche eine Messung mit demselben Kabel darstellt, welche nach einigen Tagen wiederholt aufgenommen wurde.

Schließlich ist in Fig. 3 der "S11 real"-Kurvenverlauf eines GSM-Mobiltelefons in seinem handelsüblichen Hands-Free Adapter gezeigt. Der Verlauf dieser Kurve zeigt im Bereich der Sendefrequenzen des GSM-Handys indirekt auch die Qualität der Anpassung des Antenneneingangs des Mobiltelefons. Durch wiederholte Messungen wurde herausgefunden, daß sich ein leichtes "Verkanten" des Mobiltelefons in der Halterung leicht erkennen läßt, da sich die in der Fig. 5 dargestellte Kurve dann erheblich ändert. Daher kann das erfindungsgemäße Verfahren auch zur Erkennung einer guten Ankopplung des Mobiltelefons an die Meßaufnahmeeinrichtung während eines Funktionstestes eingesetzt werden.

Die Erfindung wurde zuvor anhand von bevorzugten Ausführungsbeispielen näher erläutert. Für einen Fachmann ist es jedoch offensichtlich, daß unterschiedliche Abwandlungen und Modifikationen gemacht werden können, die im Rahmen der nachfolgenden Ansprüche fallen.

## Patentansprüche

1. Verfahren zum Testen einer Meßaufnahmeeinrichtung (3), welche in einem ersten Testbetriebsmodus zum Testen von Funkeinrichtungen zum einen mit einer Testeinrichtung (1) zum Testen der Funkeinrichtungen und zum anderen mit einer Funkeinrichtung gekoppelt ist, **dadurch gekennzeichnet, daß** ein zweiter Testbetriebsmodus zum Testen der Meßaufnahmeeinrichtung (3) vorgesehen ist, in welchem die Meßaufnahmeeinrichtung (3) zum einen mit der Testeinrichtung (1) zum Testen der Funkeinrichtungen und zum anderen mit einer im wesentlichen definierten Abschlußimpedanz (10) gekoppelt ist, wobei die Meßaufnahmeeinrichtung (3) von der Testeinrichtung (1) zum Testen von Funkeinrichtungen getestet wird.

2. Verfahren nach Anspruch 1, **dadurch gekennzeichnet, daß** zum Testen der Meßaufnahmeeinrichtung (3) die Impedanz der Meßaufnahmeeinrichtung (3), vorzugsweise der Realteil (S 11-real) der Impedanz, als Funktion der Frequenz durch die Testeinrichtung (1) aufgenommen wird.

3. Verfahren nach Anspruch 1 oder 2, **dadurch gekennzeichnet, daß** die Testeinrichtung (1) zum Testen von Funkeinrichtungen Signalgeneratormittel (4) und Empfangsmittel (5) aufweist, welche über einen einzigen I/O-Anschluß (2) miteinander verbunden sind, wobei die Meßaufnahmeeinrichtung (3) mit dem I/O-Anschluß (2) verbunden ist, und wobei wenigstens ein, in dem zweiten Testbetriebsmodus von den Signalgeneratormitteln (4) erzeugtes Signal von den Empfangsmitteln (5) aufgenommen und mit wenigstens einem vorgespeicherten Referenzwert verglichen wird.

4. Verfahren nach Anspruch 3, **dadurch gekennzeichnet, daß** die Empfangsmittel (5) zur Leistungsmessung vorgesehen sind.

5. Verfahren nach Anspruch 3 oder 4, **dadurch gekennzeichnet, daß** die Signalgeneratormittel (4) und die Empfangsmittel (5) in dem zweiten Testbetriebsmodus synchron in der Frequenz über einen vorgegebenen Frequenzbereich verstimmt werden.

6. Verfahren nach Anspruch 5, **dadurch gekennzeichnet, daß** der vorgegebene Frequenzbereich wenigstens einen Betriebsfrequenzbereich einer Funkeinrichtung aufweist.

7. Verfahren nach Anspruch 5 oder 6, **dadurch gekennzeichnet, daß** die Frequenzverstimmung schrittweise erfolgt.

8. Verfahren nach einem der Ansprüche 5 bis 7, **dadurch gekennzeichnet daß** der Pegel der von den Signalgeneratormitteln (4) erzeugten Signale während der Frequenzverstimmung konstant ist.

9. Verfahren nach einem der Ansprüche 5 bis 8, **dadurch gekennzeichnet, daß** eine über den Frequenzbereich aufgenommene Meßkurve mit einer Referenzkurve verglichen wird.

10. Verfahren nach einem der Ansprüche 3 bis 9, **dadurch gekennzeichnet, daß** die Signalgeneratormittel (4) und die Empfangsmittel (5) über einen Z/3-Stem (6) mit dem I/O-Anschluß (2) verbunden sind.

11. Verfahren nach einem der vorhergehenden Ansprüche, **dadurch gekennzeichnet, daß** der zweite Testmodus intermittierend zu dem ersten Testmodus durchgeführt wird.

12. Verfahren nach einem der vorhergehenden Ansprüche, **dadurch gekennzeichnet, daß** die Meßaufnahmeeinrichtung (3) die Abschlußimpedanz aufweist.

13. Verfahren nach Anspruch 12, **dadurch gekennzeichnet, daß** die Abschlußimpedanz ein Antennenkoppler (7) ist.

14. Verfahren nach einem der vorhergehenden Ansprüche, **dadurch gekennzeichnet, daß** die Funkeinrichtungen zum Betrieb an wenigstens einem Mobilfurilcnetz vorgesehene Mobiltelefone (10) sind.

15. Verfahren nach einem der Ansprüche 1 bis 10, **dadurch gekennzeichnet, daß** die Abschlußimpedanz (17) eine Test-Funkeinrichtung ist.

16. Verfahren nach Anspruch 14, **dadurch gekennzeichnet, daß** die Test-Funkeinrichtung ein unbestücktes Mobiltelefon ist, welches eine Ersatzimpedanz für eine koaxiale Verbindung der Meßaufnahmeeinrichtung und einem zu testenden Mobiltelefon aufweist.

17. Verfahren nach Anspruch 14 oder 15, **dadurch gekennzeichnet, daß** die Test-Funkeinrichtung mehrfach in eine Produktionslinie eingespeist wird, wobei Mittel vorgesehen sind, um die Test-Funkeinrichtung als solche zu erkennen, und um darauf ansprechend den zweiten Testbetriebsmodus auszulösen.

18. Verfahren nach einem der Ansprüche 3 bis 15, **dadurch gekennzeichnet, daß** bei einer ausreichenden Abweichung der von den Empfangsmitteln aufgenommenen Signale von den Referenzkurven ein Alarm ausgelöst wird.

19. Verfahren nach einem der Ansprüche 3 bis 16, **dadurch gekennzeichnet, daß** die Referenz in einer in der Testeinrichtung (1) vorgesehenen Spreichereinrichtung oder einem damit verbundenen externen Gerät, beispielsweise einem Computer, gespeichert wird.

20. Testeinrichtung (1) zum Testen von Funkeinrichtungen, welche in einem ersten Testbetriebsmodus zum Testen von Funkeinrichtungen mit den Funkeinrichtungen über eine Meßaufnahmeeinrichtung (3) gekoppelt ist, **dadurch gekennzeichnet, daß** die Testeinrichtung (1) einen zweiten Testbetriebsmodus zum Testen der Meßaufnahmeeinrichtung (3) aufweist, in welchem die Meßaufnahmeeinrichtung (3) zum einen mit der Testeinrichtung (1) zum Testen der Funkeinrichtungen und zum anderen mit einer im wesentlichen definierten Abschlußimpedanz gekoppelt ist, wobei die Meßaufnahmeeinrichtung (3) von der Testeinrichtung (1) zum Testen von Funkeinrichtungen getestet wird.

21. Testeinrichtung (1) nach Anspruch 20, **dadurch gekennzeichnet, daß** zum Testen der Meßaufnahmeeinrichtung (3) die Impedanz der Meßaufnahmeeinrichtung (3), vorzugsweise der Realteil (S11-real) der Impedanz, als Funktion der Frequenz durch die Testeinrichtung (1) aufgenommen wird.

22. Testeinrichtung (1) nach Anspruch 20 oder 21, **dadurch gekennzeichnet, daß** die Testeinrichtung (1) zum Testen von Funkeinrichtungen Signalgeneratormittel (4) und Empfangsmittel (5) aufweist, welche über einen einzigen I/O-Anschluß (2) miteinander verbunden sind, wobei die Meßaufnahmeeinrichtung (3) mit dem I/O-Anschluß (2) verbunden ist, und wobei wenigstens ein, in dem zweiten Testbetriebsmodus von den Signalgeneratormitteln (4) erzeugtes Signal von den Empfangsmitteln (5) aufgenommen und mit wenigstens einem vorgespeicherten Referenzwert verglichen wird.

23. Testeinrichtung (1) nach Anspruch 22, **dadurch gekennzeichnet, daß** die Empfangsmittel (5) zur Leistungsmessung vorgesehen sind.

24. Testeinrichtung (1) nach Anspruch 22 oder 23, **dadurch gekennzeichnet, daß** die Signalgeneratormittel (4) und die Empfangsmittel (5) in dem zweiten Testbetriebsmodus synchron in der Frequenz über einen vorgegebenen Frequenzbereich verstimmt werden.

25. Testeinrichtung (1) nach Anspruch 24, **dadurch gekennzeichnet, daß** der vorgegebene Frequenzbereich wenigstens einen Betriebsfrequenzbereich einer Funkeinrichtung aufweist.

26. Testeinrichtung (1) nach Anspruch 24 oder 25, **dadurch gekennzeichnet, daß** die Frequenzverstimmung schrittweise erfolgt.

27. Testeinrichtung (1) nach einem der Ansprüche 24 bis 26, **dadurch gekennzeichnet, daß** der Pegel der von den Signalgeneratormitteln (4) erzeugten Signale während der Frequenzverstimmung konstant ist.

28. Testeinrichtung (1) nach einem der Ansprüche 24 bis 27, **dadurch gekennzeichnet, daß** eine über den Frequenzbereich aufgenommene Meßkurve mit einer Referenzkurve verglichen wird.

29. Testeinrichtung (1) nach einem der Ansprüche 22 bis 28, **dadurch gekennzeichnet, daß** die Signalgeneratormittel (4) und die Empfangsmittel (5) über einen Z/3-Stern (6) mit dem I/O-Anschluß (2) verbunden sind.

30. Testeinrichtung (1) nach einem der vorhergehenden Ansprüche 20 bis 29, **dadurch gekennzeichnet, daß** der zweite Testmodus intermittierend zu dem ersten Testmodus durchgeführt wird.

31. Testeinrichtung (1) nach einem der vorhergehenden Ansprüche 20 bis 30, **dadurch gekennzeichnet, daß** die Meßaufnahmeeinrichtung (3) die Abschlußimpedanz aufweist.

32. Testeinrichtung (1) nach Anspruch 31, **dadurch gekennzeichnet, daß** die Abschlußimpedanz ein Antennenkoppler (7) ist.

33. Testeinrichtung (1) nach einem der vorhergehenden Ansprüche 20 bis 32, **dadurch gekennzeichnet, daß** die Funkeinrichtungen zum Betrieb an wenigstens einem Mobilfunknetz vorgesehene Mobiltelefone (10) sind.

34. Testeinrichtung (1) nach einem der Ansprüche 20 bis 30, **dadurch gekennzeichnet, daß** die Abschlußimpedanz (17) eine Test-Funkeinrichtung ist.

35. Testeinrichtung (1) nach Anspruch 33, **dadurch gekennzeichnet, daß** die Test-Funkeinrichtung ein unbestücktes Mobiltelefon ist, welches eine Ersatzimpedanz für eine koaxiale Verbindung der Meßaufnahmeeinrichtung und einem zu testenden Mobiltelefon aufweist.

36. Testeinrichtung (1) nach Anspruch 33 oder 34, **dadurch gekennzeichnet, daß** die Test-Funkeinrichtung mehrfach in eine Produktionslinie eingespeist wird, wobei Mittel vorgesehen sind, um die Test-Funkeinrichtung als solche zu erkennen, und um darauf ansprechend den zweiten Testbetriebsmodus auszulösen.

37. Testeinrichtung (1) nach einem der Ansprüche 22 bis 35, **dadurch gekennzeichnet, daß** bei einer ausreichenden Abweichung der von den Empfangsmitteln aufgenommenen Signale von den Referenzkurven ein Alarm ausgelöst wird.

38. Testeinrichtung (1) nach einem der Ansprüche 22 bis 36, **dadurch gekennzeichnet, daß** die Referenz in einer in der Testeinrichtung (1) vorgesehenen Speichereinrichtung oder einem damit verbundenen externen Gerät, beispielsweise einem Computer, gespeichert wird.

39. Verwendung einer Testeinrichtung (1) zum Testen von Funkeinrichtungen zum Testen einer daran gekoppelten Meßaufnahmeeinrichtung (3) mittels einer Impedanzmessung nach zumindest einen der Ansprüche 20 bis 38.

## Claims

1. Method for testing a measurement recording device (3) which, in a first test operating mode for testing radio devices, is coupled firstly to a test device (1) for testing the radio devices and secondly to a radio device, **characterized in that** a second test operating mode for testing the measurement recording device (3) is provided, in which the measurement recording device (3) is coupled firstly to the test device (1) for testing the radio devices and secondly to an essentially defined terminating impedance (10), with the measurement recording device (3) being tested by the test device (1) for testing radio devices.

2. Method as claimed in claim 1, **characterized in that** the impedance of the measurement recording device (3), preferably the real part (S11-real) of the impedance, is recorded as a function of the frequency by the test device (1) in order to test the measurement recording device (3).

3. Method as claimed in claim 1 or 2, **characterized in that** the test device (1) for testing radio devices has signal generator means (4) and receiving means (5) which are connected to one another via a single I/O connection (2), with the measurement recording device (3) being connected to the I/O connection (2), and with at least one signal which is produced by the signal generator means (4) in the second test operating mode being received by the receiving means (5) and then compared with at least one previously stored reference value.

4. Method as claimed in claim 3, **characterized in that** the receiving means (5) are provided for power measurement.

5. Method as claimed in claim 3 or 4, **characterized in that** the frequencies of the signal generator means (4) and of the receiving means (5) are tuned synchronously over a predetermined frequency range in the second test operating mode.

6. Method as claimed in claim 5, **characterized in that** the predetermined frequency range has at least one operating frequency range of a radio device.

7. Method as claimed in claim 5 or 6, **characterized in that** the frequency tuning is carried out in steps.

8. Method as claimed in any of claims 5 to 7, **characterized in that** the level of the signals which are produced by the signal generator means (4) is constant during the frequency tuning.

9. Method as claimed in any of claims 5 to 8, **characterized in that** a measurement curve, which is recorded over the frequency range, is compared with a reference curve.

10. Method as claimed in any of claims 3 to 9, **characterized in that** the signal generator means (4) and the receiving means (5) are connected to the I/O connection (2) via a Z/3 star (6).

11. Method as claimed in any of the preceding claims, **characterized in that** the second test mode is carried out intermittently with respect to the first test mode.

12. Method as claimed in any of the preceding claims, **characterized in that** the measurement recording device (3) comprises the terminating impedance.

13. Method as claimed in claim 12, **characterized in that** the terminating impedance is an antenna coupler (7).

14. Method as claimed in any of the preceding claims, **characterized in that** the radio devices are mobile telephones (10) which are intended to be operated in at least one mobile radio network.

15. Method as claimed in any of claims 1 to 10, **characterized in that** the terminating impedance (17) is a test radio device.

16. Method as claimed in claim 14, **characterized in that** the test radio device is an unequipped mobile telephone which has an equivalent impedance for a coaxial connection of the measurement recording device and a mobile telephone to be tested.

17. Method as claimed in claim 14 or 15, **characterized in that** the test radio device is fed two or more times into a production line, with means being provided in order to identify the test radio device as such and, in response thereto, in order to initiate the second test operating mode.

18. Method as claimed in any of claims 3 to 15, **characterized in that** an alarm is triggered if a sufficient discrepancy is found between the reference curves and the signals recorded by the receiving means.

19. Method as claimed in any of claims 3 to 16, **characterized in that** the reference is stored in a memory device that is provided in the test device (1), or in an external appliance which is connected to it, for example a computer.

20. Test device (1) for testing radio devices, which is coupled to the radio devices via a measurement recording device (3) in a first test operating mode for testing radio devices, **characterized in that** the test device (1) has a second test operating mode for testing the measurement recording device (3), in which second test operating mode the measurement recording device (3) is coupled firstly to the test device (1) for testing the radio devices and secondly to an essentially defined terminating impedance, with the measurement recording device (3) being tested by the test device (1) for testing radio devices.

21. Test device (1) as claimed in claim 20, **characterized in that** the impedance of the measurement recording device (3), preferably the real part (S11 real) of the impedance, is recorded as a function of the frequency by the test device (1) in order to test the measurement recording device (3).

22. Test device (1) as claimed in claim 20 or 21, **characterized in that** the test device (1) for testing radio devices has signal generator means (4) and receiving means (5) which are connected to one another via a single I/O connection (2), with the measurement recording device (3) being connected to the I/O connection (2), and with at least one signal which is produced by the signal generator means (4) in the second test operating mode being received by the receiving means (5) and then compared with at least one previously stored reference value.

23. Test device (1) as claimed in claim 22, **characterized in that** the receiving means (5) are provided for power measurement.

24. Test device (1) as claimed in claim 22 or 23, **characterized in that** the frequencies of the signal generator means (4) and of the receiving means (5) are tuned synchronously over a predetermined frequency range in the second test operating mode.

25. Test device (1) as claimed in claim 24, **characterized in that** the predetermined frequency range has at least one operating frequency range of a radio device.

26. Test device (1) as claimed in claim 24 or 25, **characterized in that** the frequency tuning is carried out in steps.

27. Test device (1) as claimed in any of claims 24 to 26, **characterized in that** the level of the signals which are produced by the signal generator means (4) is constant during the frequency tuning.

28. Test device (1) as claimed in any of claims 24 to 27, **characterized in that** a measurement curve, which is recorded over the frequency range, is compared with a reference curve.

29. Test device (1) as claimed in any of claims 22 to 28, **characterized in that** the signal generator means (4) and the receiving means (5) are connected to the I/O connection (2) via a Z/3 star (6).

30. Test device (1) as claimed in any of the preceding claims 20 to 29, **characterized in that** the second test mode is carried out intermittently with respect to the first test mode.

31. Test device (1) as claimed in any of the preceding claims 20 to 30, **characterized in that** the measurement recording device (3) comprises the terminating impedance.

32. Test device (1) as claimed in claim 31, **characterized in that** the terminating impedance is an antenna coupler (7).

33. Test device (1) as claimed in any of the preceding claims 20 to 32, **characterized in that** the radio devices are mobile telephones (10) which are intended to be operated in at least one mobile radio network.

34. Test device (1) as claimed in any of claims 20 to 30, **characterized in that** the terminating impedance (17) is a test radio device.

35. Test device (1) as claimed in claim 33, **characterized in that** the test radio device is an unequipped mobile telephone which has an equivalent impedance for a coaxial connection of the measurement recording device and a mobile telephone to be tested.

36. Test device (1) as claimed in claim 33 or 34, **characterized in that** the test radio device is fed two or more times into a production line, with means being provided in order to identify the test radio device as such and, in response thereto, in order to initiate the second test operating mode.

37. Test device (1) as claimed in any of claims 22 to 35, **characterized in that** an alarm is triggered if a sufficient discrepancy is found between the reference curves and the signals recorded by the receiving means.

38. Test device (1) as claimed in any of claims 22 to 36, **characterized in that** the reference is stored in a memory device that is provided in the test device (1), or in an external appliance which is connected to it, for example a computer.

39. Use of a test device (1) for testing radio devices for testing a measurement recording device (3), which is coupled to it, by means of an impedance measurement according to at least one of the claims 20 to 38.

## Revendications

1. Procédé pour tester un dispositif de mesure (3), lequel dans un premier mode de test, pour tester des appareils radioélectriques, est couplé d'une part à un dispositif de test (1), pour tester des appareils radioélectriques, et est d'autre part couplé à un appareil radioélectrique, **caractérisé en ce qu'**un deuxième mode de test est prévu pour tester le dispositif de mesure (3), dans lequel le dispositif de mesure (3) est couplé d'une part au dispositif de test (1) pour tester les appareils radioélectriques, et d'autre part est couplé à une impédance terminale (10) essentiellement définie, où le dispositif de mesure (3) est testé par le dispositif de test (1) d'appareils radioélectriques.

2. Procédé selon la revendication 1, **caractérisé en ce que**, pour tester le dispositif de mesure (3), on utilise le dispositif de test (1) pour mesurer l'impédance du dispositif de mesure (3), de préférence la partie réelle (S11-réelle) de l'impédance, en fonction de la fréquence.

3. Procédé selon la revendication 1 ou 2, **caractérisé en ce que** le dispositif de test (1) pour le test d'appareils radioélectriques possède des moyens générateurs de signaux (4) et des moyens récepteurs (5), lesquels sont reliés entre eux par une connexion d'entrée-sortie (2) unique, où le dispositif de mesure (3) est relié à la connexion d'entrée-sortie (2), et où au moins un signal, émis par les moyens générateurs de signaux (4) dans le deuxième mode de test, est capté par les moyens récepteurs (5) et est comparé à au moins une valeur de référence gardée en mémoire.

4. Procédé selon la revendication 3, **caractérisé en ce que** les moyens récepteurs (5) sont prévus pour réaliser des mesures de puissance.

5. Procédé selon la revendication 3 ou 4, **caractérisé en ce que**, dans le deuxième mode de test, les moyens générateurs de signaux (4) et les moyens récepteurs (5) sont ajustés en mode non-résonant synchrone en fréquence sur une plage de fréquence donnée.

6. Procédé selon la revendication 5, **caractérisé en ce que** la plage de fréquence donnée comporte au moins une bande de fréquences attribuée à un appareil radioélectrique.

7. Procédé selon la revendication 5 ou 6, **caractérisé en ce que** la non-résonance des fréquences est réalisée par étapes.

8. Procédé selon l'une quelconque des revendications 5 à 7, **caractérisé en ce que** le niveau des signaux produits par les moyens générateurs de signaux (4) est constant pendant la mise en non-résonance des fréquences.

9. Procédé selon l'une quelconque des revendications 5 à 8, **caractérisé en ce qu'**une courbe de mesure captée sur la plage de fréquences est comparée à une courbe de référence.

10. Procédé selon l'une quelconque des revendications 3 à 9, **caractérisé en ce que** les moyens générateurs de signaux (4) et les moyens récepteurs (5) sont reliés à la connexion d'entrée-sortie (2) via une étoile Z/3 (6).

11. Procédé selon une des revendications ci-dessus, **caractérisé en ce que** le deuxième mode de test est exécuté de manière intermittente avec le premier mode de test.

12. Procédé selon une des revendications ci-dessus, **caractérisé en ce que** le dispositif de mesure (3) présente l'impédance terminale.

13. Procédé selon la revendication 12, **caractérisé en ce que** l'impédance terminale est constituée par un coupleur d'antenne (7).

14. Procédé selon une des revendications ci-dessus, **caractérisé en ce que** les appareils radioélectriques sont constitués de téléphones mobiles (10) prévus pour fonctionner sur au moins un réseau mobile.

15. Procédé selon l'une quelconque des revendications 1 à 10, **caractérisé en ce que** l'impédance terminale (17) est constituée par un appareil radioélectrique de test.

16. Procédé selon la revendication 14, **caractérisé en ce que** l'appareil radioélectrique de test est constitué par un téléphone mobile non-équipé, lequel possède une impédance équivalente à une connexion coaxiale du dispositif de mesure et d'un téléphone mobile à tester.

17. Procédé selon la revendication 14 ou 15, **caractérisé en ce que** l'appareil radioélectrique de test est connecté par une connexion multiple à une ligne de production, où des moyens sont prévus pour permettre de reconnaître l'appareil radioélectrique de test, et pour déclencher le deuxième mode de test correspondant.

18. Procédé selon l'une quelconque des revendications 3 à 15, **caractérisé en ce qu'**advenant un écart suffisant entre les signaux reçus par les moyens récepteurs et les courbes de référence, une alarme est déclenchée.

19. Procédé selon l'une quelconque des revendications 3 à 16, **caractérisé en ce que** la référence est stockée dans une mémoire prévue dans le dispositif de test (1), ou dans un appareil externe relié à ce dernier, par exemple dans un ordinateur.

20. Dispositif de test (1) destiné à réaliser des tests d'appareils radioélectriques, lequel pour tester des appareils radioélectriques dans un premier mode de test est couplé aux appareils radioélectriques via un dispositif de mesure (3), **caractérisé en ce fait que** le dispositif de test (1) possède un deuxième mode de test pour tester le dispositif de mesure (3) ; dans ce mode le dispositif de mesure (3) est couplé d'une part avec le dispositif de test (1) d'appareils radioélectriques, et d'autre part avec une impédance terminale essentiellement définie, où le dispositif de mesure (3) est testé par le dispositif de test (1) d'appareils radioélectriques.

21. Dispositif de test (1) selon la revendication 20, **caractérisé en ce que**, pour tester le dispositif de mesure (3), on utilise le dispositif de test (1) pour mesurer l'impédance du dispositif de mesure (3), de préférence la partie réelle (S11-réelle) de l'impédance, en fonction de la fréquence.

22. Dispositif de test (1) selon la revendication 20 ou 21, **caractérisé en ce que** le dispositif de test (1) pour le test des appareils radioélectriques possède des moyens générateurs de signaux (4) et des moyens récepteurs (5), lesquels sont reliés entre eux par une connexion d'entrée-sortie (2) unique, où le dispositif de mesure (3) est relié à la connexion d'entrée-sortie (2), et où au moins un signal émis par les générateurs de signaux (4) dans le deuxième mode de test est capté par les moyens récepteurs (5) et est comparé avec au moins une valeur de référence gardée en mémoire.

23. Dispositif de test (1) selon la revendication 22, **caractérisé en ce que** les moyens récepteurs (5) sont prévus pour réaliser des mesures de puissance.

24. Dispositif de test (1) selon la revendication 22 ou 23, **caractérisé en ce que**, dans le deuxième mode de test, les moyens générateurs de signaux (4) et les moyens récepteurs (5) sont ajustés en mode non-résonant synchrone en fréquence sur une plage de fréquence donnée.

25. Dispositif de test (1) selon la revendication 24, **caractérisé en ce que** la plage de fréquence donnée comporte au moins une bande de fréquences attribuée à un appareil radioélectrique.

26. Dispositif de test (1) selon la revendication 24 ou 25, **caractérisé en ce que** la non-résonance des fréquences est réalisée par étapes.

27. Dispositif de test (1) selon l'une quelconque des revendications 24 à 26, **caractérisé en ce que** le niveau des signaux produits par les moyens générateurs de signaux (4) est constant pendant la mise en non-résonance des fréquences.

28. Dispositif de test (1) selon l'une quelconque des revendications 24 à 27, **caractérisé en ce qu'**une courbe de mesure captée sur la plage de fréquences est comparée à une courbe de référence.

29. Dispositif de test (1) selon l'une quelconque des revendications 22 à 28, **caractérisé en ce que** les moyens générateurs de signaux (4) et les moyens récepteurs (5) sont reliés à la connexion d'entrée-sortie (2) via une étoile Z/3 (6).

30. Dispositif de test (1) selon l'une quelconque des revendications 20 à 29 ci-dessus, **caractérisé en ce que** le deuxième mode de test est exécuté de manière intermittente avec le premier mode de test.

31. Dispositif de test (1) selon l'une quelconque des revendications 20 à 30 ci-dessus, **caractérisé en ce que** le dispositif de mesure (3) présente l'impédance terminale.

32. Dispositif de test (1) selon la revendication 31, **caractérisé en ce que** l'impédance terminale est constituée d'un coupleur d'antenne (7).

33. Dispositif de test (1) selon l'une quelconque des revendications 20 à 32 ci-dessus, **caractérisé en ce que** les appareils radioélectriques sont constitués de téléphones mobiles (10) prévus pour fonctionner sur au moins un réseau de téléphonie mobile.

34. Dispositif de test (1) selon l'une quelconque des revendications 20 à 30, **caractérisé en ce que** l'impédance terminale (17) est constituée d'un appareil radioélectrique de test.

35. Dispositif de test (1) selon la revendication 33, **caractérisé en ce que** l'appareil radioélectrique de test est constitué d'un téléphone mobile non-équipé, lequel possède une impédance équivalente à une connexion coaxiale du dispositif de mesure et d'un téléphone mobile à tester.

36. Dispositif de test (1) selon la revendication 33 ou 34, **caractérisé en ce que** l'appareil radioélectrique de test est connecté par une connexion multiple à une ligne de productiõn, où des moyens sont prévus pour permettre de reconnaître l'appareil radioélectrique de test, et pour déclencher le deuxième mode de test correspondant.

37. Dispositif de test (1) selon l'une quelconque des revendications 22 à 35, **caractérisé en ce qu'**advenant un écart suffisant entre les signaux reçus par les récepteurs et les courbes de référence, une alarme est déclenchée.

38. Dispositif de test (1) selon l'une quelconque des revendications 22 à 36, **caractérisé en ce que** la référence est stockée dans une mémoire prévue dans le dispositif de test (1), ou dans un appareil externe relié à ce dernier, par exemple dans un ordinateur.

39. Utilisation d'un dispositif de test (1) destiné à tester des appareils radioélectriques pour tester un dispositif de mesure (3) qui lui est connecté, au moyen d'une mesure de l'impédance selon au moins une des revendications 20 à 38.
